(19) Europäisches Patentamt / European Patent Office / Office européen des brevets

(11) **EP 3 029 488 B1**

(12) **EUROPÄISCHE PATENTSCHRIFT**

(45) Veröffentlichungstag und Bekanntmachung des Hinweises auf die Patenterteilung:
**27.02.2019  Patentblatt 2019/09**

(51) Int Cl.:
**G01S 17/42** *(2006.01)*    **G01S 7/481** *(2006.01)*
**G01S 7/484** *(2006.01)*

(21) Anmeldenummer: **14196329.8**

(22) Anmeldetag: **04.12.2014**

(54) **Distanzmessgerät mit einer Laser-artigen Lichtquelle**

Distance measuring device with a laser-type light source

Télémètre équipé d'une source lumineuse de type laser

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**08.06.2016  Patentblatt 2016/23**

(73) Patentinhaber: **Hexagon Technology Center GmbH**
**9435 Heerbrugg (CH)**

(72) Erfinder:
• **Stutz, Reto**
  **9442 Berneck (CH)**
• **Hinderling, Jürg**
  **9437 Marbach (CH)**

(74) Vertreter: **Kaminski Harmann**
**Patentanwälte AG**
**Landstrasse 124**
**9490 Vaduz (LI)**

(56) Entgegenhaltungen:
EP-A1- 1 517 415          EP-A1- 1 589 353
EP-A2- 0 665 446          EP-A2- 1 335 457
DE-A1-102004 031 097      US-A1- 2009 316 134

• JOHN E FULENVIDER: "SOME POTENTIAL IMPACTS OF OPTICAL FIBER TRANSMISSION AND INTEGRATED OPTICS ON WORLD COMMUNICATIONS", IEEE INTERCON CONFERENCE RECORD,, 1. Januar 1975 (1975-01-01), Seiten 1-6, XP001621812,
• DOLFI-BOUTEYRE A ET AL: "Pulsed 1.5- $\mu$ m LIDAR for Axial Aircraft Wake Vortex Detection Based on High-Brightness Large-Core Fiber Amplifier", IEEE JOURNAL OF SELECTED TOPICS IN QUANTUM ELECTRONICS, IEEE SERVICE CENTER, PISCATAWAY, NJ, US, Bd. 15, Nr. 2, 1. März 2009 (2009-03-01), Seiten 441-450, XP011344178, ISSN: 1077-260X, DOI: 10.1109/JSTQE.2008.2010463
• EITAN E. ROWEN ET AL: "A combined Yb-Raman fiber amplifier for generating narrow linewidth, high-power pulses in the 1100-1200 nm wavelength range and efficient nonlinear conversion into yellow", PROCEEDINGS OF SPIE, Bd. 8601, 22. Februar 2013 (2013-02-22), Seiten 86011J-86011J-8, XP055080588, ISSN: 0277-786X, DOI: 10.1117/12.2003831

**Beschreibung**

Die Erfindung betrifft eine laserartige Lichtquelle eines Distanzmessgeräts, insbesondere für einen Laser-Scanner, einen Profiler oder einen Theodoliten.

Im Bereich der elektronischen bzw. elektrooptischen Distanzmessung sind verschiedene Prinzipien und Verfahren bekannt. Ein Ansatz besteht darin, gepulste elektromagnetische Strahlung, wie z.B. Laserlicht, auf ein zu vermessendes Ziel auszusenden und nachfolgend ein Echo von diesem Ziel als rückstreuendes Objekt zu empfangen, wobei die Distanz zum zu vermessenden Ziel anhand der Laufzeit des Pulses bestimmt wird. Solche Pulslaufzeitmesser haben sich mittlerweile in vielen Bereichen als Standardlösungen durchgesetzt.

EP 1 335 457 A2 offenbart einen entsprechenden Distanzmesser.

Heutige mit einer Laserlichtquelle ausgestattete Distanzmesser beispielsweise eines Laserscanners mit hoher Messgenauigkeit, insbesondere kleinem Distanzrauschen, zeigen in den damit erzeugten Datenpunktwolken jedoch häufig Artefakte, wie beispielsweise Intensitätsrauschen und deuten darin wellige, unebene Oberflächen (Bumpy Surfaces) anstelle tatsächlich vorhandener ebener, glatter abgetasteter und abzubildender Oberflächen an. Das Auftreten von Intensitätsrauschen von Laserlicht ergibt sich bekannter Weise insbesondere beim Anzielen rauer Oberflächen mit Laserlicht. Das zurückgestreute Licht weist dabei eine körnige Granulation der Helligkeit auf.

Als "Speckles-Muster" von gestreutem Licht oder einfach kurz "Speckles" werden die körnigen Interferenzphänomene bezeichnet, die sich bei für die Verursachung dieses Phänomens sowohl räumlich als auch zeitlich hinreichend kohärenter Beleuchtung von optisch rauen Objektoberflächen beobachten lassen. Die verursachenden Unebenheiten der lichtstreuenden Oberflächen haben dabei Abmessungen in einer Grössenordnung zwischen der Wellenlänge des Laserlichts und einigen 10 $\mu$m.

Speckles entstehen, falls hochkohärente Lichtstrahlung auf inhomogene, im aktuellen Fall auf Objekte mit einer rauen Oberfläche, fällt, das Licht anschliessend transmittiert oder reflektiert wird und sich in Richtung Detektor ausbreitet. Das gestreute Licht zeigt die vorgenannte Granulation. Die gestreute Strahlung hat eine irreguläre Feld- und Intensitätsverteilung und in Ausbreitungsrichtung näherungsweise zigarrenartige Formgebilde (Bereiche mit hoher Energiedichte). Auf dem Empfangsobjektiv des Distanzsensors ist dann eine granulare Intensitätsverteilung beobachtbar. Die empfangene Leistung und damit das Empfangssignal variiert in unregelmässiger Weise, wenn der Scanner mit dem Laserstrahl über das zu vermessende Objekt bewegt wird. Dieser Effekt gibt eine unnatürliche Helligkeitswiedergabe des Objekts. Zudem sind die Distanzmesswerte verrauscht.

Die Bezeichnung "Speckle", die sowohl für einen einzelnen Lichtfleck als auch für das gesamte Interferenzmuster verwendet wird, leitet sich vom englischen Wort "speckle" = "Flecken, Tupfen" ab. Abhängig vom verwendeten Abbildungssystem wird zwischen "subjektiven" und "objektiven" Speckles unterschieden: Bildet man die Speckles ohne Zuhilfenahme einer Linse oder anderer optischer Geräte direkt auf einen Schirm oder eine Kamera ab, spricht man von "objektivem" Speckle.

Die Speckles-Verteilung bzw. deren Veränderung kann, im Fall von "objektiven" Speckles, in einfacher Weise mittels eines Papierblatts als Projektionsfläche in der Umgebung der durch den Laser beleuchteten Oberfläche beobachtet werden. Die Durchschnittsgrösse der Speckles in diesen Interferenzmustern wird vor allem bestimmt durch die Wellenlänge des kohärenten Anregungslichts, den Durchmesser des Anregungslichtstrahls oder, äquivalent dazu, die Grösse der beleuchteten Fläche, und die zugehörige Geometrie.

Bei "subjektiven" Speckles hingegen ist eine Abbildung des Interferenzmusters mit Hilfe eines optischen Systems beteiligt - hierzu zählt auch das menschliche Auge. Wird das von einem streuenden Objekt erzeugte Lichtmuster mittels eines optischen Systems abgebildet, dann wird das Speckles-Muster im Bild als "subjektv" bezeichnet, und die mittlere Speckle-Grösse ist dann von den optischen Parametern des abbildenden Systems abhängig, wie beispielsweise Brennweite f und Pupillendurchmesser $d_e$.

Falls die Lichtquelle mehrere Moden M aufweist, beispielsweise in einer Weise wie gepulste Fabry-Perot Laserdioden (FP), dann entstehen M, im Mittel unabhängige, Speckles-Felder. Diese M Felder überlagern inkohärent, die Intensitäten summieren sich auf und die Schwankung der Empfangssignalstärke beim Verschwenken des Laserstrahls über das Zielobjekt ist um einen Faktor der Quadratwurzel von M reduziert. Bei einer spektral breitbandigen Lichtquelle, wie beispielsweise einer superlumineszenten Diode (SLD), ist dieser Glättungseffekt verstärkt, da das Spektrum breiter als bei gängigen Multimode-Laserdioden ist und das Spektrum einer SLD zusätzlich keine Lücken aufweist.

Die typische Grösse der Speckles an der Stelle der Empfangspupille, aber auch an der Feldblende bei der Empfangsdiode, kann berechnet werden. Der mittlere Speckle-Durchmesser beträgt etwa:

$$d_{speckle} := \frac{\pi \cdot \lambda \cdot \text{Dist}}{d_{spot}}$$

Dabei bedeuten "Dist" die Distanz zwischen der beleuchteten Fläche und der Empfangspupille und "$d_{spot}$" der Strahldurchmesser auf der beleuchteten Fläche.

Bei nahen Zielen haben die Speckles eher eine feine Granulation; mit zunehmender Distanz werden sie grösser. Falls das Messlichts des Lasers auf unendlich fokussiert ist, ist zu beobachten, dass ab einer Distanz von einigen 10 m die Speckles-Grösse nicht mehr weiter zunimmt und in etwa die Ausdehnung des Sendestrahls in der Sendepupille annimmt.

$$d_{speckle} = d_{TX}$$

Um Speckles quantitativ beschreiben zu können, muss das elektromagnetische Feld des von einer rauen Oberfläche rückgestreuten Lichts genauer betrachtet werden. Das elektromagnetische Feld variiert dabei in Amplitude und Phase. Mathematisch werden solche Phasoren in komplexer Schreibweise als Kombination eines realen und eines imaginären Feldanteil beschrieben, wobei im einfachsten Fall beide durch den Streuprozess als verteilt gemäss einer Gauss-Funktion angenommen werden. Die zugehörigen Verteilungen des Betrags der Feldamplitude und der Phase sind Rayleigh-Verteilungen beziehungsweise "gleich"-verteilt. Die Verteilungsdichtefunktion der Intensität von gestreutem, kohärenten Licht an einem Punkt der Empfangs-apertur verläuft negativ-exponentiell:

$$p(I) = \frac{1}{Im} \cdot \exp\left(\frac{-I}{Im}\right)$$

Dabei bedeuten "I" die Intensität gemessen an einem Punkt und "Im" den Mittelwert der Intensität des Strahlungsfelds. Der Kontrast CON einer solchen monochromatischen Strahlung gemessen mit einem punktförmigen Detektor ist CON=1.

Für die Definition des Speckles-Kontrasts gibt es mehrere Konventionen. Eine häufig verwendete ist folgende, und sie zeigt den Zusammenhang mit dem Signal-Rausch-Verhältnis:

Kontrast der Intensität:

$$CON := \frac{\sigma I}{Im} = \frac{1}{SNR}$$

Reduktion des Kontrasts:

$$CON = \frac{1}{\sqrt{M}}$$

Bei monochromatischem Laserlicht wie bei einer DFB-Laserdiode ist M=1. Der Kontrast CON beträgt daher 100%, die an verschiedenen Punkten gemessene Intensität streut um 100%. Dieser Wert der normierten Helligkeitsstreuung ist mittels der zugehörigen statistischen Verteilungsdichte der Intensität (negativ exponentielle Verteilung) einfach herzuleiten.

Im Fall einer Lichtquelle mit mehreren M Moden nehmen der Kontrast und damit das Intensitätsrauschen proportional zur Quadratwurzel von M ab.

Im Fall einer solchen Lichtquelle mit mehreren Moden M, beispielsweise in einer Weise wie gepulste Fabry-Perot-Laserdioden, entstehen M im Mittel unabhängige Speckles-Felder. Diese überlagern hauptsächlich inkohärent, die Intensitäten summieren sich auf und die Schwankung der Empfangssignalstärke beim Verschwenken des Laserstrahls über das Zielobjekt ist mit Wurzel M reduziert.

Folgende Formel gibt die Verteilungsdichte der Intensität an einem Messpunkt für eine Lichtquelle mit M Moden an. Diese Formel gilt auch für einen räumlichen Mittelungsprozess, wie er bei einer grossen Empfangsapertur mit M lateralen Korrelationszellen stattfindet, das heisst in der Empfangsapertur befinden sich M Speckles.

Normierte Intensität: $I_k := \dfrac{k}{K}$  I=[0..1]

Mittlere Intensität: Im := 0.5

Verteilungsdichte als Funktion der Intensität I und der Anzahl M von Moden oder diskreten Laser-Wellenlängen:

$$p(I,M) := \left(\frac{M}{Im}\right)^{M} \cdot \frac{I^{M-1}}{\Gamma(M)} \cdot \exp\left(-M \cdot \frac{I}{Im}\right)$$

$\Gamma(M)$ steht dabei für die Gammafunktion.

Die Tiefenrauheit der Oberfläche des Zielobjekts spielt ebenfalls eine Rolle. Falls die Oberfläche nur eine geringe Rauheit aufweist oder die transversale Beschaffenheit der Oberfläche zu gleichförmig ist (transversale Korrelationslänge), dann dekorrelieren die Phasen der rückgestreuten Teilwellen des elektromagnetischen Feldes nicht ausreichend, und die Speckles weisen eine Resthelligkeitsschwankung auf, die zwischen der Exponentialverteilung und einer Rice-Verteilung mit gut geglätteten Speckles liegt.

Auch die transversale Grösse des Laserpunkts am Zielobjekt beeinflusst die Qualität der gemessenen Punktwolken. Die beobachtete Grösse der Helligkeitsflecken, aber auch die Bereiche der, wenn auch nur geringen, Distanzfehler (<0.5mm) beim Vermessen von homogenen Oberflächen steht auch im Zusammenhang mit der Grösse des Laserpunkts auf dem gescannten Objekt. Bei einem Objektscan wird der Laserstrahl über die Oberfläche verschwenkt, wobei sich das Speckles-Muster auf dem Detektor des Distanzmesssensors verändert. Das Speckles-Muster scheint sich stetig, aber fliessend zu verändern. Die Form des Musters ist dekorreliert, sobald der Lasermessfleck auf dem Objekt sich um einen Strahlquerschnitt bewegt hat. Da mit der Speckles-Verteilung auch eine systematische Distanz-Messabweichung verknüpft ist, zeigt die gemessene Oberfläche eine wellige Distanzabweichung (Bumpy Surfaces).

Gemäss Stand der Technik sind Distanzmesssensoren für geodätische oder industrielle Vermessungsgeräte in der Regel mit einem Laser als Lichtquelle ausgerüstet. Als Laser werden dabei typischerweise verwendet:

- Laserdioden und Festkörperlaser, jeweils ausgebildet mit singlemode oder multimode Spektren , wobei die multimodigen Spektren typischerweise eine Breite von etwa 1.5 nm aufweisen;
- Sogenannte "seeded Fiberamplifiers" (d.h. das Licht einer Anregungslichtquelle verstärkende Lichtfaser-Verstärker);
- Fiberlaser;
- "High Radiance LED" (Lichtemittierende Hochleistungsdioden) .

Bis auf die LED sind alle vorgenannten Lichtquellen mit dem Nachteil einer ausgeprägten granularen Intensitätsverteilung des von natürlich streuenden oder reflektierenden Oberflächen rückgestreuten Lichts verbunden. "High Radiance LED" haben den Nachteil einer geringen Strahldichte und werden daher nicht für Messungen auf diffus streuende Ziele eingesetzt. Auch die Modulationsgeschwindigkeit von LED ist limitiert. Kürzeste Signal-Anstiegszeiten sind im Bereich von einigen Nanosekunden. Wegen einer zu geringen Modulationsbandbreite werden solche Dioden für signalempfindliche Distanzmesser mit hoher Genauigkeit nicht mehr eingesetzt.

Da Speckles ein spezielles Phänomen von räumlich und zeitlich kohärenter Beleuchtung sind, können der Speckles-Kontrast und Speckles-Einfluss durch diverse Massnahmen reduziert werden. Es sind z.B. folgende Techniken zur Speckles-Reduktion bekannt:

- Bewegen des Sendelichtflecks auf dem Zielobjekt;
- Radiales Bewegen des Empfangsobjektivs;
- Bewegen oder Vibrieren eines Diffusors im Sendestrahl quer zur Strahlrichtung;
- Verwenden eines Diffusors mit kleinem Streuwinkel;
- Einsetzen von zwei Diffusoren im Sendekanal mit deren gegenläufiger Bewegung quer zum Laserstrahl;
- Verwenden von "Polarisationsvielfalt", d.h. gleichzeitige Emission von Licht mit diversen Polarisationszuständen.

Da der Lichtfleck am Zielobjekt möglichst klein sein soll, ist eine Reduktion der räumlichen Kohärenz in der Regel nicht möglich, sofern nicht der Gegenstand sehr nahe angeordnet ist und die Sendeoptik derart fokussierbar ist, dass der Lichtfleck eine ausreichend kleine Ausdehnung am Zielobjekt beibehält. (Unter dem Begriff "ausreichend kleine Ausdehnung" ist dabei eine Abmessung immer noch weit grösser als die Beugungsgrenze des Lichts zu verstehen).

Anderseits kann ein zeitlich dynamischer Diffusor die räumliche Kohärenz reduzieren. Dabei kann der dynamische Diffusor beispielsweise ausgebildet sein als ein bewegtes Hologramm, ein vibrierendes Phasenobjekt, ein Flüssigkristall als optischer Phasenschieber oder als ein EO-Phasenmodulator. All diese Methoden haben allerdings den Nachteil, die Strahldivergenz zu erhöhen. Insbesondere eine konstante Phasenschiebung quer über den gesamten Bündelquerschnitt ist im Beugungsfernfeld wegen den in Streurichtung länglichen Strukturen der Speckles nicht zielführend.

Einige Verfahren sind verbunden mit zeitlicher Mittelung von Speckles-Feldern, wofür eine gewisse Integrationszeit benötigt wird. Da aber Scanning als ein sehr schneller Messvorgang mit einer Messrate von typischerweise 1 MPts/s oder mehr benutzt wird, sind diese Mittelungsmethoden nicht einsetzbar.

Als eine weitere Methode kann für den Fall, dass mehr als ein Speckle in die Empfangs-Apertur fällt, Speckles-Reduktion mit Beobachtung/Messung einer ausgedehnten Empfangsapertur erzielt werden. Mittels integrierter Intensität über mehrere Speckles verfeinert sich die Körnigkeit des Lichtflecks an der Detektorfläche. Diese auf der Empfangsdiode integrierte Intensität weist eine reduzierte Variation der Intensität auf.

Da die Baugrösse moderner Vermessungsgeräte laufend kleiner wird ist allerdings eine effektive Mittelung und damit Speckles-Reduktion allein nicht ausreichend.

Aufgabe der Erfindung ist die Bereitstellung einer Lichtquelle für ein Vermessungsgerät, insbesondere einen Laser-Scanner, einen Profiler oder einen Theodoliten, mit der die mit einer hochkohärenten Lichtquelle verbundenen Nachteile, insbesondere die Erzeugung von Speckles und daraus resultierende Verfälschungen von Distanzmessungen und Abbildungen einer zu vermessenden Objektoberfläche vermieden oder zumindest minimiert werden und ein gemessenes Distanzrauschen minimiert wird. Eine Aufgabe der Erfindung ist es dabei auch, zugleich eine hochpräzise Anmessung der Oberfläche zu ermöglichen.

Eine weitere Aufgabe der Erfindung ist das Unterdrücken von Speckles-induziertem Intensitätsrauschen, um ein möglichst realitätsnahes Bild mit einer unverfälschten Helligkeitsverteilung des Objekts zu erhalten.

Diese Aufgaben werden durch die Gegenstände der unabhängigen Ansprüche gelöst. Vorteilhafte Weiterbildungen sind den Gegenständen der abhängigen Ansprüche zu entnehmen.

Die Erfindung betrifft einen elektrooptischen Distanzmesser für ein Vermessungsgerät, insbesondere für einen Laserscanner, Lasertracker, Profiler, Theodoliten oder eine Totalstation.

Der Distanzmesser weist dabei Lichtaussendemittel zum Aussenden wenigstens eines Lichtsignals, insbesondere eines Lichtpulses, und einem Empfänger zum Detektieren des von einem Zielobjekt zurückgestreuten Lichtsignals auf. Anhand einer Steuer- und Auswertekomponente wird die Distanz zum Zielobjekt bestimmt, beispielsweise auf das Pulslaufzeitmessverfahren basierend.

Gemäss der Erfindung sind die Lichtaussendemittel im Gegensatz zum Stand der Technik aufgebaut aus wenigstens einer spektral breitbandigen Lichtquelle (d.h. einem spektral breitbandig lichtemittierenden Halbleiter-Bauelement) als primärer Lichtquelle und einem der primären Lichtquelle nachgeschalteten optischen Verstärker, für den die primäre Lichtquelle also als Seedquelle dient.

Insbesondere wirkt ein aktiv gepumptes Medium des optischen Verstärkers Resonator-los (also ohne optischen Resonator) als Lichtverstärker. Der optische Verstärker kann dabei dazu vorgesehen und ausgebildet sein, um mit einer Modulationsfolge mit einem kurzen und/oder langen Duty-Cycle betrieben zu werden.

Bei der Seedquelle für den optischen Verstärker (insbesondere ausgebildet als Faserverstärker) kann es sich erfindungsgemäss vorteilhaft um eine Superlumineszenzdiode (SLD) mit einer spektralen Breite von zwischen 7nm und 50nm handeln (insbesondere wobei das Spektrum in dieser Breite dann im Wesentlichen lückenfrei abgedeckt ist).

Die als Seed für den optischen Verstärker infrage kommende primäre Lichtquelle kann also - im Allgemeinen - insbesondere eine Diode (z.B. Superlumineszenzdiode oder High-Radiance-LED) sein, die vom Aufbau her einer Laserdiode ähnlich ist, jedoch ohne Laserresonator (bzw. Kavität) ausgebildet ist.

Alternativ kann erfindungsgemäss jedoch auch eine Multimodelaserdiode als primäre Lichtquelle (also als Seed für den optischen Verstärker) eingesetzt werden (beispielsweise eine Fabry-Perot-Laserdiode mit Multimode-Emission). Insbesondere kann die primäre Lichtquelle also ausgebildet sein als eine Halbleiterlaserdiode, welche mehrere Moden und polychromatisches Licht mit mehreren Spektrallinien aussendet. Die primäre Lichtquelle kann im Speziellen auch ausgebildet sein als eine Breitstreifen-Laserdiode oder VCSEL-Laserdiode (Vertical Cavity Surface Emitting Laser), welche spatial mehrmodig und polychromatisches Licht, insbesondere mit einer spatialen Emissionsbreite von zwischen 10 $\mu$m und 300 $\mu$m, aussendet.

Im Rahmen der Erfindung kann dabei die zum Einsatz kommende primäre Lichtquelle der Distanzmesser-Lichtaussendemittel - gemäss einer ersten Möglichkeit - selbst jeweils direkt moduliert werden (also direkt elektrisch gesteuert durch den entsprechenden elektrischen Strom, mit dem das eingesetzte lichtemittierende Halbleiter-Bauelement betrieben wird). Andererseits kann jedoch auch eine externe Modulation zum Einsatz kommen, wobei die aussendende Diode (also die primäre Seed-Lichtquelle) im kontinuierlichen Modus betrieben wird und das ausgesendete Licht dann durch ein "externes Gerät" (wie etwa ein akustooptischer Modulator AOM oder elektrooptischer Modulator EOM) optisch moduliert wird (vgl. z.B. "Externally Modulated LED").

Durch beide Modulations-Möglichkeiten lassen sich dann z.B. die für eine Pulslaufzeitmessung benötigten Lichtpulse erzeugen, insbesondere - als Beispiel - wobei dadurch dann Pulse mit einer Wiederholrate von zwischen 500 kHz und 10 MHz ausgesendet werden.

Ferner kann die Seed-Lichtquelle beispielsweise auch in einem Burstmode betrieben werden, wobei dadurch eine Reduktion des Einflusses des chromatischen Delays auf die Distanzmessung erzielbar ist.

Um eine möglichst hohe örtliche Messauflösung zu garantieren, kommen erfindungsgemäss insbesondere solche Lichtquellen für die Distanzmessung in Frage, die räumlich einmodig emittieren oder in einer Modenkombination strahlen, die in etwa einem Profil eines TEM00-Modes entspricht. Um auch eine schnelle Messung mit einer Messrate von einem Megahertz oder schneller zu ermöglichen, sind auch zeitliche Mittelungen anspruchsvoll. Soll zudem noch jeder Messpunkt am Zielobjekt mittels eines Einzel-Laserimpulses aufgenommen werden, dann ist nur noch eine zeitlich parallele Methode zur Reduktion des Speckles-Kontrasts oder Speckles-Rauschen in Erwägung zu ziehen.

Gemäss der erfinderischen Idee ist dieses durch eine erhebliche spektrale Verbreiterung der Lichtquelle erreichbar (verglichen mit klassischen, kohärentes Licht emittierenden Laserquellen).

Wie bereits erwähnt soll als primäre Seed-Lichtquelle erfindungsgemäss insbesondere eine superlumineszente Diode (SLD) eingesetzt werden. Die spektralen Breiten liegen je nach Typ zwischen 7 nm und 50 nm. Besonders vorteilhaft ist dabei die Wahl einer SLD, bei der das Spektrum keine Lücken zeigt, wodurch eine besonders effiziente Rauschunterdrückung der Speckles ermöglicht wird.

SLD-Lichtquellen sind allerdings für eine Anwendung in der Distanzmesstechnik als alleinige Lichtquelle nicht hinreichend leistungsstark. Die derzeit stärksten erreichen weniger als 50 Milliwatt. Reguläre Laserdioden hingegen erreichen Leistungen bis gegen 10 Watt, Breitstreifen-Laser bis einige 100 Watt und VCSEL-Arrays von mehr als 1000 Watt.

Damit die Lichtaussendemittel eine ausreichend hohe Leistung erzeugen, wird erfindungsgemäss der SLD ein optischer Verstärker nachgeschaltet.

Es stehen im Wesentlichen drei Typen von optischen Verstärkern zur Verfügung:

- Faserverstärker dotiert mit einem Metall der Seltenen Erden (YDFA, EDFA, ...) ;
- Faserbasierte Raman-Verstärker (SiO2, ...);
- Halbleiter Verstärker (SOA)
- Kristallverstärker wie regenerativer Verstärker und optisch parametrischer Verstärker (optical parametric amplifier, OPA).

Erfindungsgemäss können grundsätzlich aktiv gepumpte Medien ohne Resonator als Lichtverstärker dienen.

Die effizientesten Verstärker sind die mit Seltenen Erdmetallen dotierten Gläser oder Kristalle. Raman-Verstärker haben eine um ca. 20dB geringere Verstärkung und sind daher weniger geeignet; auch die Halbleiter (InGaP, GaAs, InGaAs, ...) basierten Verstärker (SOA) sind nicht ausreichend stark für gepulsten Betrieb mit kurzem Duty-Cycle. Eine besondere Variante der auf seltenen Erden beruhenden Verstärker sind die Glasfaserverstärker. Diese sind besonders effizient und haben eine kompakte Bauform.

Erfindungsgemäss wird eine SLD als primäre Lichtquelle daher vorzugsweise mit einem Faserverstärker kombiniert. Als Dotierung können dabei Y, Yb, Pr, Ho, Tm oder Er zur Anwendung kommen. Auch Co-Dotierungen sind möglich, beispielsweise mit Pr & Ho. Damit ist eine Verstärkung in zusätzlichen Wellenlängenbereichen erreichbar.

Vorteilhaft kann ein solcher Faserverstärker gewählt werden, der einen Faserkerndurchmesser aufweist, welcher grösser ist als das Beugungslimit, insbesondere mit einer so genannten "large core" Faser. Damit kann auch das von einer Seedquelle mit grosser Emissionsfläche ausgesendete Licht (d.h. also Licht, das von einer primären Lichtquelle mit grosser Emissionsfläche ausgesendete wird) effizient in den Verstärker eingekoppelt werden.

Zur Erfüllung der Aufgabe der vorliegenden Erfindung bieten Lichtaussendemittel mit einer Kombination aus einer SLD (oder einer flächenemittierenden High-Radiance LED) und einem Faser-Verstärker (d.h. Fiberamplifier) insbesondere folgende Vorteile:

- Leistungsstarke, spektral inkohärente Lichtquelle;
- Reduktion des Helligkeitskontrasts des Speckles- Felds;
- bessere statistische Verteilung oder Mittelung der Modulationsfehler bezüglich sowohl spektraler als auch räumlicher Verteilung, dieses sowohl bei "TOF" als auch phasenartigen Modulationen.

Dabei wird unter "TOF"-Modulation eine Modulation mit Einzelschüssen oder wenigen Schüssen pro Messpunkt mit kleinem Duty-Cycle zwischen den Burstpaketen oder Modulationsimpulsen verstanden (für eine Distanzmessung nach dem Pulslaufzeitprinzip). Unter "Phasen"-Modulation wird eine Modulation mit dauerstrichartigen, periodischen oder pseudo-periodischen Schüssen mit grossem Duty-Cycle, also kleinen Pausen, zwischen den Modulationsimpulsen verstanden (für eine Distanzmessung, die grundsätzlich nach dem Prinzip der Phasenmessung erfolgt).

Auch können dem Faserverstärker mehrere SLD als Seed vorgeschaltet werden.

Dadurch ergeben sich beispielsweise folgende Effekte:

- Keine oder lediglich schwache Speckles, geringere Intensitätsstreuung, natürlichere Intensitätsbilder;
- Keine "Bumpy Surfaces" von Objekten, insbesondere auch dadurch geringeres Distanzrauschen;

Auch bei Oberflächen mit geringer Rauigkeit ergibt sich noch eines gutes, d.h. hohes, Signal-Rausch-Verhältnis (SNR). Denn mit abnehmender Standardabweichung der Rauigkeit nimmt die Korrelation unter der rückgestreuten Strahlung (Phasoren der gestreuten Kugel- oder Dipolwellen) zu. Das breite Spektrum der erfinderischen Lichtquelle wirkt dieser Korrelation aber entgegen.

Eine erfindungsgemäss alternative oder zusätzliche bzw. ergänzende Massnahme zur Kontrastreduktion betrifft Speckles in der Empfangspupille des Distanzmessers.

Der mittlere Speckle-Durchmesser $d_{speckle}$ an der Stelle der Empfangspupille beträgt etwa:

$$d_{speckle} := \frac{\pi \cdot \lambda \cdot \text{Dist}}{d_{spot}}$$

Falls das Messlichts des Lasers auf unendlich fokussiert ist, ist zu beobachten, dass ab einer Distanz von einigen 10 m die Speckles-Grösse $d_{speckle}$ nicht mehr weiter zunimmt und in etwa die Ausdehnung der Sendepupille $d_{TX}$ annimmt.

$$d_{speckle} = d_{TX}$$

Speckles-Reduktion kann daher mit einer im Vergleich zur Sendeapertur (TX-Apertur) viel grösseren Empfangsapertur (RX-Apertur) erreicht werden. Die dadurch gleichzeitig eingefangenen vielen Speckles tragen zu einer Mittelung der Intensität bei. Werden beispielsweise M Speckles auf den Detektor gelenkt, so verringert sich die Streuung des Signals mit der Quadratwurzel von M. Ist die Empfangsoptik nicht auf das Zielobjekt, sondern auf unendlich grosse Distanz fokussiert, so befinden sich viele Streuer der rauen Oberfläche innerhalb der Airy-Auflösung der Punkt-übertragungsfunktion ("point spread function") der Empfangsoptik. Dadurch wird der ganze Sendelichtfleck am Zielobjekt einsehbar, und eine grössere Fläche oder Ausdehnung trägt zu einer möglichen Phasen-Dekorrelation bei. Durch das ausgedehnte Gesichtsfeld trägt die gesamthaft ausgeleuchtete Fläche und damit eine grössere Anzahl von lateral dekorrelierten Streuern am Objekt zum Aufpunkt gebildet durch den Detektor bei. Damit findet ein Mittelungsprozess der Speckles-bedingten Signalschwankung statt.

Eine Kombination der beiden erfinderischen Schritte (SLD/LED & grosse Empfangsapertur) erzeugt ein Empfangssignal mit kleinerem Rauschen, gutem Signal-Rausch-Verhältnis, insbesondere einerseits wegen reduzierter Granulation des Streufelds und anderseits kleinerem Intensitätsrauschen durch zusätzliche Mittelung auf dem Detektor.

Mit zunehmender Zahl von Lasermoden oder Spektrallinien nimmt die Intensitätsstreuung auf dem Empfänger ab. Dieses ist ersichtlich durch schmalere Verteilungskurven in Intensitätshistogrammen, welche sich immer enger um die mittlere Intensität platzieren.

Aus dieser Tatsache ergibt sich erfindungsgemäss ein Ansatz zur Kontrastverminderung: Ein statistisch vergleichbarer Mittelungseffekt entsteht nämlich auch beim Empfangen von gleichzeitig mehreren Speckles mittels grosser Empfängerfläche wie bereits oben beschrieben.

Mit zunehmender Zahl von Speckles in der Empfangspupille entsteht ein integrierender Effekt über die in das Empfangsobjektiv einfallenden Speckles. Dadurch wird die Helligkeitsvariation des Empfangssignals reduziert. Damit wird auch der Speckles-Kontrast reduziert und die Signalvariation schwächt sich ab.

Die statistische Berechnung der zugehörigen Kontrastfunktion führt zur selben Formel wie oben angegeben; dabei steht dann M für die Anzahl der Speckles in der Empfangspupille oder auf der Feldblende (M = Anzahl der Speckle-Korrelationszellen innerhalb der Messungsempfangs-Apertur).

Gemäss einer Ausführungsform ist daher die erfinderische Distanzmessvorrichtung mit einer im Vergleich zur Senderapertur möglichst grossen Empfangsapertur oder Empfangspupille ausgerüstet. Dadurch ist gewährleistet, dass in erster Näherung praktisch unabhängig vom Distanzbereich eine grosse Anzahl M von Speckles empfangen werden. Damit wird der Speckles-Kontrast reduziert, oder gleichbedeutend, das Signal-Rausch-Verhältnis (SNR) erhöht. Mit dieser Massnahme werden natürlichere Bilder mit geringer Helligkeitsschwankung gemessen. Auch die Distanzmessung zeigt geringere Variationen der registrierten Distanzwerte.

Auch die Rauheit der Objekte beeinflusst die Helligkeitsverteilung der Speckles. Je grösser die Rauheit der Oberfläche, umso gleichmässiger ist das Empfangslicht, jedoch nur bis zu einer gewissen Grenze, die eben auch von der Polychromasie der Lichtquelle und der Grösse der Empfangs-apertur abhängt.

Auch die transversale Grösse des Laserpunkts am Zielobjekt beeinflusst die Qualität der gemessenen Koordinaten und damit Punktwolken.

Dieses ist folgendermassen zu erklären: Die gepulsten oder andersartig modulierten Lichtquellen von Distanzmessern weisen einen sogenannten chromatischen Delay auf. Dieser Delay beschreibt den Distanz-Offset in Abhängigkeit von der Lichtquellenwellenlänge. Da jeder Mode oder jede Wellenlänge ihr zugeordnetes Speckles-Feld erzeugen und die Speckles-Verteilung auch von der Rauheit der angestrahlten Oberfläche abhängt, ist auch der Distanz-Offset beeinflusst. Mittels des chromatischen Delays und der jeweiligen Speckles-Verteilung entstehen daher die wellenartigen Distanzabweichungen. Wird der Laserpunkt nun um mindestens einen Strahldurchmesser über das Zielobjekt verschoben, dann entsteht ein neu strukturiertes granulares Lichtfeld, und damit eine zur vorhergehenden Messung unkorrelierte Distanzabweichung.

Mit der erfinderischen Lichtquelle für Distanzmesser, welche in einer speziellen Ausführung eine SLD und einen Faserverstärker umfasst, sind sowohl die Intensitätsvariationen der Speckles als auch der Effekt zum Entstehen der wellenartigen Distanzabweichungen stark abgeschwächt. Die spektrale Breite $\Delta\lambda$ einer SLD ist im Wesentlichen etwa zehnmal breiter als diejenige von Laserdioden. Zudem ist das Spektrum ohne Unterbrüche. Diese Kontinuität verstärkt die Reduktion des Speckles-Kontrasts.

Für eine Beispielsrechnung werden folgende Parameter angenommen:

$$\lambda o := 660 \cdot 10^{-9}$$

$$\Delta\lambda := 30 \cdot 10^{-9}$$

$$\sigma h := 500 \cdot 10^{-6}$$

Dabei sind $\lambda o$ die Mittenwellenlänge und $\Delta\lambda$ die spektrale Breite der Lichtquelle und $\sigma h$ die Tiefenrauheit der Zieloberfläche.

Damit ergibt sich als HelligkeitsKontrast:

$$CON := \sqrt{\frac{1}{4 \cdot \pi} \cdot \frac{\lambda o}{\Delta\lambda} \cdot \frac{\lambda o}{\sigma h}} = 0.048$$

Die Intensitätsvariation beträgt also nur noch 4.8 % statt 100 % für hoch kohärente Strahlung.

Die obige Näherungsformel gilt für die Annahme eines Gauss-verteilten Spektrums und einer Gauss-verteilten Rauheit der Oberfläche. Die Formel zeigt auch für den Fall einer spektral breitbandigen ($\Delta\lambda$) Lichtquelle wie der SLD, dass wiederum auch die Oberflächenrauheit $\sigma h$ zur Kontrastreduktion beiträgt.

Falls die SLD mit Subnanosekunden-Pulsen moduliert wird, dann ist auch der chromatische Delay, welcher die absolute Distanzmessgenauigkeit mitbeeinflusst, klein. Dadurch sind keine oder zumindest stark abgeschwächte wellenartige Distanzabweichungen zu erzielen.

Im Grenzfall einer Weisslichtquelle verschwindet erstaunlicherweise die spatiale Kohärenz am Ort des Detektors nicht. Die verbleibende räumliche Kontrastfunktion (Visibility) wird durch das in der Astronomie bekannte Van Cittert-Zernike Theorem beschrieben. Die erfinderische Anordnung ist gekennzeichnet durch eine mittlere Situation zwischen dieser inkohärenten und kohärenten Beleuchtung.

Die Erfindung wird nachfolgend anhand von in den Zeichnungen schematisch dargestellten konkreten Ausführungsbeispielen rein beispielhaft näher beschrieben, wobei auch auf weitere Vorteile der Erfindung eingegangen wird. Im Einzelnen zeigen:

Fig.1    die Prinzipdarstellung eines elektrooptischen Distanzmessers;

Fig.2    die Prinzipdarstellung eines Laufzeitmessverfahrens nach dem Stand der Technik;

Fig.3    die Prinzipdarstellung eines Abtastverfahrens für zurückgestreute Lichtsignale nach dem Stand der Technik;

Fig. 4    den Verlauf der Verteilungsdichte als Funktion der normierten Intensität $I_k$ für ein, zwei, sechs und zehn Moden Laser (M diskrete Laser-Wellenlängen), als eine Illustration einer Möglichkeit zur Speckles-Kontrastreduktion bei polychromatischen Lichtquellen;

Fig. 5    Wahrscheinlichkeiten der Helligkeitsverteilung p(I) für verschiedene Oberflächen-Rauigkeiten $\sigma$;

Fig. 6    eine typische Messanordnung mit einem Distanzmessgerät nach dem Stand der Technik;

Fig. 7a    die Speckles-Verteilung, die sich für eine monochromatische Messlichtquelle in einer Entfernung von 15 m von einem lichtstreuenden Objekt in der Querschnittsebene des Empfangsobjektivs des Distanzmessgeräts ergibt;

Fig. 7b    die zu Fig. 7a zugehörige Häufigkeitsverteilung der Intensität der Speckles;

Fig. 7c    in einer zu Fig. 7a analogen Darstellung die Speckles-Verteilung, die sich für eine polychromatische Messlichtquelle mit 5 Lasermoden in einer Entfernung von 15 m vom lichtstreuenden Objekt in der Querschnittsebene des Empfangsobjektivs ergibt;

Fig. 7d    die zu den Bilddaten von Fig. 7c gehörige Häufigkeitsverteilung der Speckles;

Fig. 7e    zum Vergleich mit Fig. 7a, die SpecklesVerteilung, die sich für eine monochromatische Messlichtquelle in einer Entfernung von 5 m vom lichtstreuenden Objekt in der Querschnittsebene des Empfangsobjektivs ergibt;

Fig. 8    entsprechend einer Messanordnung mit einer monochromatischen Lichtquelle, mit der die in den Figuren 7a, 7c und 7e dargestellten Speckles-Verteilungen beobachtet werden, den scheinbaren Offset und die Streuung der aus der Bildauswertung abgeleiteten Distanzwerte als Funktion der Messdistanz zum lichtstreuenden Objekt;

Fig. 9a    ein Spektrum einer FP-Laserdiode (Fabry-Perot) bei multimodaler Emission und gepulster Betriebsart;

Fig. 9b    für einen Vergleich mit Fig. 9a das Spektrum einer DFB-Laserdiode bei einzelmodaler Emission und gepulster Betriebsart;

Fig. 9c    das Spektrum einer SLD-Diode, als Bestandteil einer Lichtquelle für ein erfindungsgemässes Distanzmessgerät, mit breitbandiger Emission ohne Spektrallinien, bei gepulster Betriebsart;

Fig. 10    das spektrale Emissionsprofil eines Signals mit einer multimodalen Laserdiode nach einem Faserverstärker, basierend auf $Er^{3+}$-Glas (links) und $Er^{3+}$-ZBLAN (rechts), nach einmaligem Durchlauf des Seed-Lichts der Laserdiode durch den Verstärker;

Fig. 11    eine Illustration zur Entstehung des sogenannten "chromatic delay" oder "chromatic distance-offset" einer modulierten Lichtquelle als Mechanismus zur Entstehung von "Bumpy Surfaces", mit einer Lichtquelle, deren Spektrum beispielhaft in Fig. 9a dargestellt wurde;

Fig. 12    eine Illustration zur Verdeutlichung des Problems einer vermeintlichen, durch Speckles induzierten, gemessenen Oberflächenrauigkeit (Bumpy Surface) anhand von zwei Beispielen von mit einem DFB-Laser gescannten Oberflächen;

Fig. 13    ein Blockschaltbild einer erfindungsgemässen Lichtquelle für eine erfindungsgemässe Distanzmessvorrichtung, mit einer SLD als primärer Lichtquelle und einem der SLD im optischen Weg nachgeschalteten optischen Verstärker;

Fig. 14 eine Illustration zur Verdeutlichung der Verminderung des Einflusses bzw. Kontrasts durch die Speckles mittels einer statistischen Mittelung über ein Empfangsbild einer gross ausgedehnten Empfangspupille; und

Fig. 15 ein Messresultat mit, erfindungsgemäss, einer breitbandigen Lichtquelle und einem grossen Aperturverhältnis von Empfangs- zu Sendeapertur, welches Bild zu vergleichen ist mit der Darstellung in der linken Hälfte von Fig. 12.

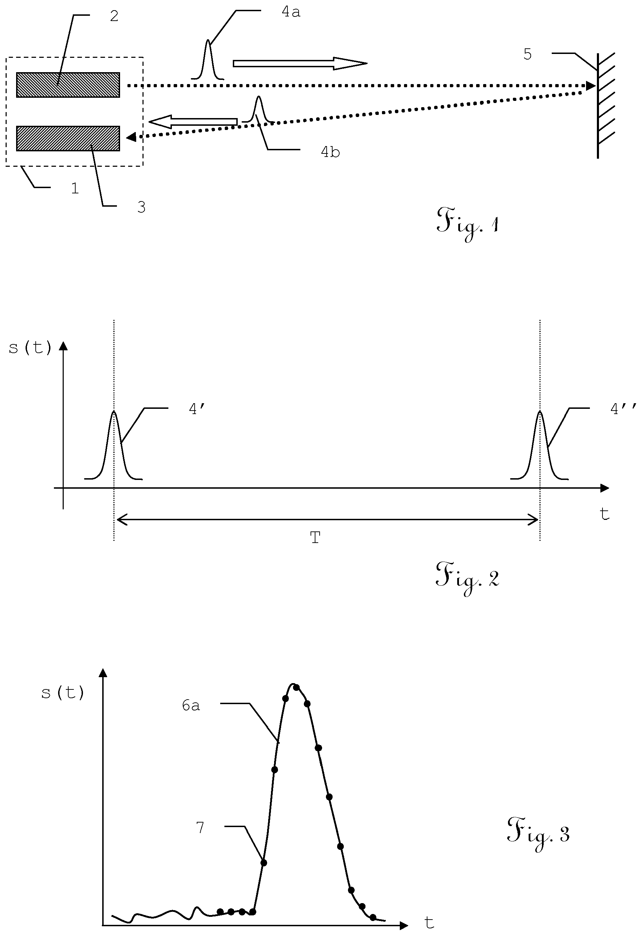

Fig. 1 zeigt die Prinzipdarstellung eines elektrooptischen Distanzmessers 1 nach dem Pulslaufzeitprinzip. In dem Distanzmesser 1 sind Lichtaussendemittel 2 und ein Empfänger 3 angeordnet. Der Sender 2 emittiert einen Lichtpuls 4a, der nach der Reflektion bzw. Rückstreuung an einem Ziel 5, z.B. einer Objektoberfläche, wieder als zurückgestreuter Lichtpuls 4b vom Empfänger 3 detektiert wird. Anstelle der Lichtpulse kann erfindungsgemäss auch ein kontinuierlich moduliertes Sendesignal verwendet werden.

Der Empfänger 3 kann dabei - wie dies an sich aus dem Stand der Technik hinlänglich bekannt ist - aufgebaut sein mit einen Detektor, beispielsweise einer Avalanche-Photodiode (APD), und einer dem Detektor nachgeschalteten Signalverarbeitungselektronik.

In einer speziellen Ausführungsform kann ferner auch mit einer aus mehreren Segmenten bestehenden Empfangsdiode, insbesondere einer mehrsegmentigen PIN-Diode oder APD, aufgebaut sein. Ein solcher Aufbau für die Empfangsdiode eines Distanzmessers ist beispielsweise in der Europäischen Patentanmeldung mit der Anmeldenummer EP14185404.2 (beim EPA eingereicht am 18. September 2014) beschrieben.

Wie dies ebenso grundsätzlich bereits aus dem Stand der Technik bekannt ist kann der Empfänger (d.h. der optische Empfangspfad) entweder mit einem Fixfokus oder mit einem Autofokus ausgerüstet sein.

Wie in Fig.2 in Prinzipdarstellung erläutert, kann die Entfernung - wie dies grundsätzlich bekannt ist - aus der Laufzeit T als zeitliche Differenz zwischen dem Startzeitpunkt S des Aussendens eines Lichtpulses 4' und dem Empfangszeitpunkt des zurückgestreuten Lichtpulses 4'' ermittelt werden (wobei dies durch die Steuer- und Auswertekomponente durchgeführt wird). Die Ermittlung des Empfangszeitpunktes erfolgt dabei durch die Auswertung eines Merkmals des Signalimpulses s(t), z.B. durch das Überschreiten einer Signalschwelle oder durch Schwerpunktbestimmung des integrierten Pulsverlaufs. Wie erwähnt sind beim Schwellwertverfahren auch andere Methoden zur Messung der Laufzeit T nutzbar, wie beispielsweise die Umwandlung des Empfangssignals in ein bipolares Signal und anschliessende Bestimmung des Nulldurchgangs.

Fig.3 veranschaulicht das Prinzip eines Abtastverfahrens für zurückgestreute Lichtsignale nach dem Stand der Technik. Ein empfangenes Signal 6a bzw. dessen Signalverlauf wird zu verschiedenen Zeitpunkten 7 bzw. zugeordneten Zeitintervallen abgetastet, so dass sich die Signalform ableiten lässt. Dadurch kann (für die Laufzeitbestimmung) ggf. der Aussende- und Empfangszeitpunkt präziser und besser miteinander vergleichbar abgeleitet werden.

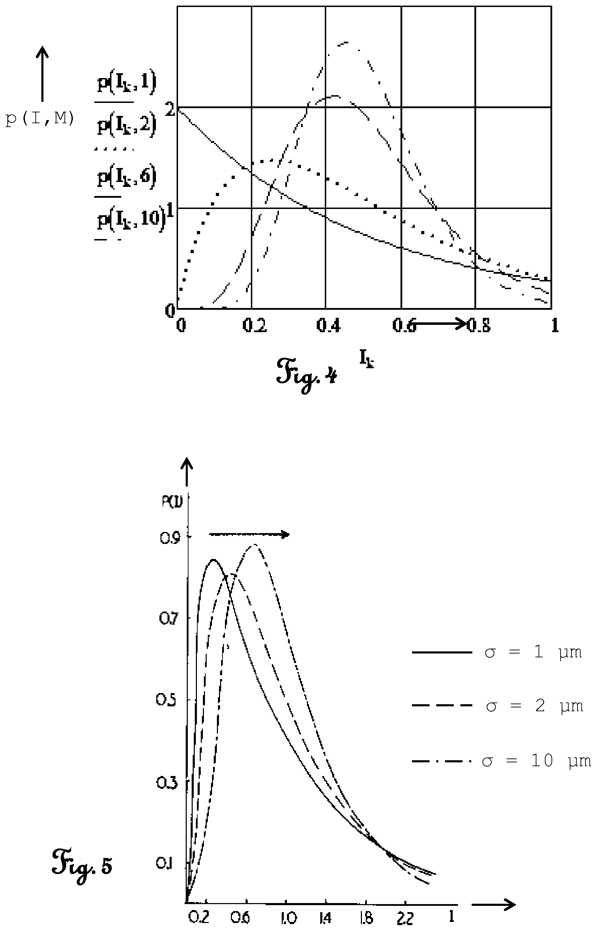

Fig. 4 illustriert eine Möglichkeit zur Speckles-Kontrastreduktion bei polychromatischen Lichtquellen.

Falls die Lichtquelle mehrere Moden M aufweist, beispielsweise in einer Weise wie gepulste Fabry-Perot-Laserdioden, dann entstehen M im Mittel unabhängige Speckles-Felder. Diese überlagern inkohärent, die Intensitäten summieren sich auf, und die Schwankung der Empfangssignalstärke beim Verschwenken des Laserstrahls über das Zielobjekt ist mit Quadratwurzel M reduziert.

Fig. 4 zeigt den Verlauf der Verteilungsdichte p(I,M) als Funktion der normierten Intensität $I_k$ für ein, zwei, sechs und zehn Moden oder diskrete Laser-Wellenlängen M.

Die Verteilungsdichte berechnet sich wie folgt:

Normierte Intensität: $I_k := \dfrac{k}{K}$

Mittlere Intensität: Im := 0.5

Verteilungsdichte als
Funktion der Intensität
I und der Anzahl M von
Moden oder diskreten

Laser-Wellenlängen:

$$p(I,M) := \left(\frac{M}{Im}\right)^M \cdot \frac{I^{M-1}}{\Gamma(M)} \cdot \exp\left(-M \cdot \frac{I}{Im}\right)$$

Mit zunehmender Zahl von Lasermoden oder Spektrallinien nimmt die Intensitätsstreuung auf dem Empfänger ab. Dieses ist ersichtlich durch schmalere Verteilungskurven, welche sich immer enger um die mittlere Intensität platzieren.

Fig. 5 zeigt Wahrscheinlichkeiten der Helligkeitsverteilung P(I) für verschiedene Oberflächen-Rauigkeiten $\sigma$. Der Pfeil in der Mitte der Graphik verdeutlicht die Verschiebung des Verteilungsmaximums bei Zunahme der Rauigkeit. Zudem ist eine Art Sättigungseffekt zu sehen, bei welchem bei einer weiteren Zunahme der Rauheit der Oberfläche keine Abnahme des Intensitätskontrasts mehr auftritt. Der Grund dafür liegt in der begrenzten Polychromasie der Lichtquelle. Für diese Grafik wurde eine Lichtquelle mit lediglich 6 Wellenlängen angenommen, der Mittelungsprozess umfasst daher nur 6 Summanden.

Die Rauheit der Objekte beeinflusst also die Helligkeitsverteilung der Speckles. Je grösser die Rauheit der Oberfläche, umso gleichmässiger ist das Empfangslicht, jedoch nur bis zu einer gewissen Grenze, die eben auch von der Polychromasie der Lichtquelle und der Grösse der Empfangs-apertur abhängt.

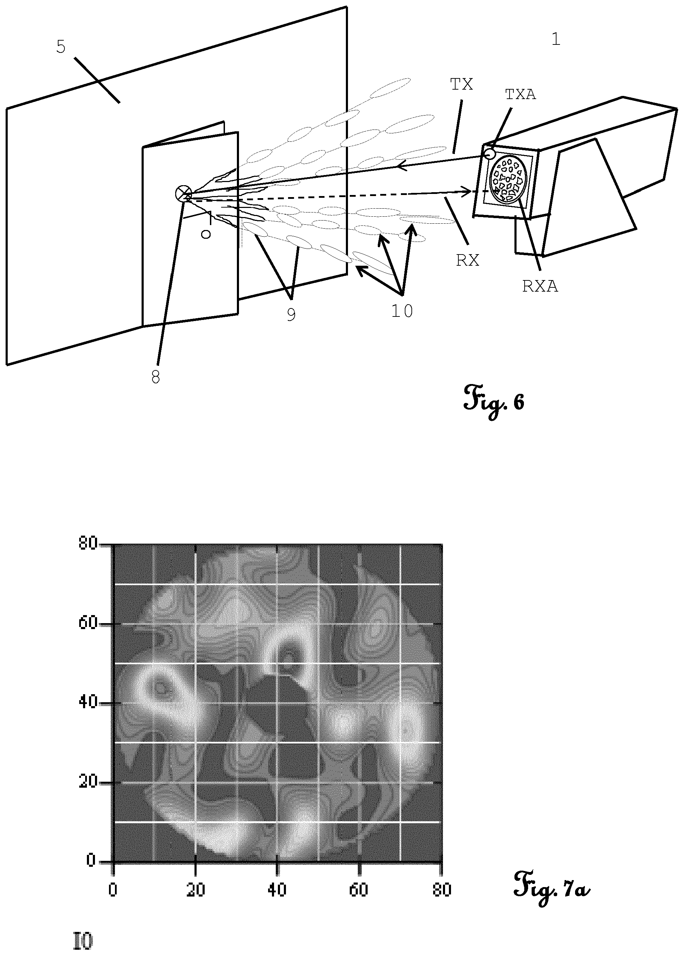

Fig. 6 zeigt eine typische Messanordnung mit einem Distanzmessgerät 1 nach dem Stand der Technik. Das Distanzmessgerät 1 sendet aus einer Sendeapertur TXA einen Sendestrahl TX von kohärentem Messlicht in Richtung eines zu vermessenden Objekts 5 aus, wodurch dort ein Lichtfleck 8 des auftreffenden Messlichts erzeugt wird. Das vom Objekt reflektierte Licht RX zur Entfernungsmessung weist eine Vielzahl von Speckles 9 auf, die ein Speckles-Feld 10 im Raum erzeugen, welches auf die Empfangsapertur RXA des Distanzmessgeräts 1 mit einer granularen Intensitätsverteilung auftrifft.

Die Figuren 7a bis 7e illustrieren typische Speckles-Muster am Empfangsobjektiv des Distanzmessgeräts bei verschiedenen Ziel- oder Objektabständen.

Dabei zeigt Fig. 7a die Speckles-Verteilung, die sich für eine monochromatische Messlichtquelle in einer Entfernung von 15 m vom lichtstreuenden Objekt in der Querschnittsebene des Empfangsobjektivs ergibt. Es gibt mehrere Stellen ohne Licht. Bei monochromatischer Beleuchtung sind diese sogar am häufigsten.

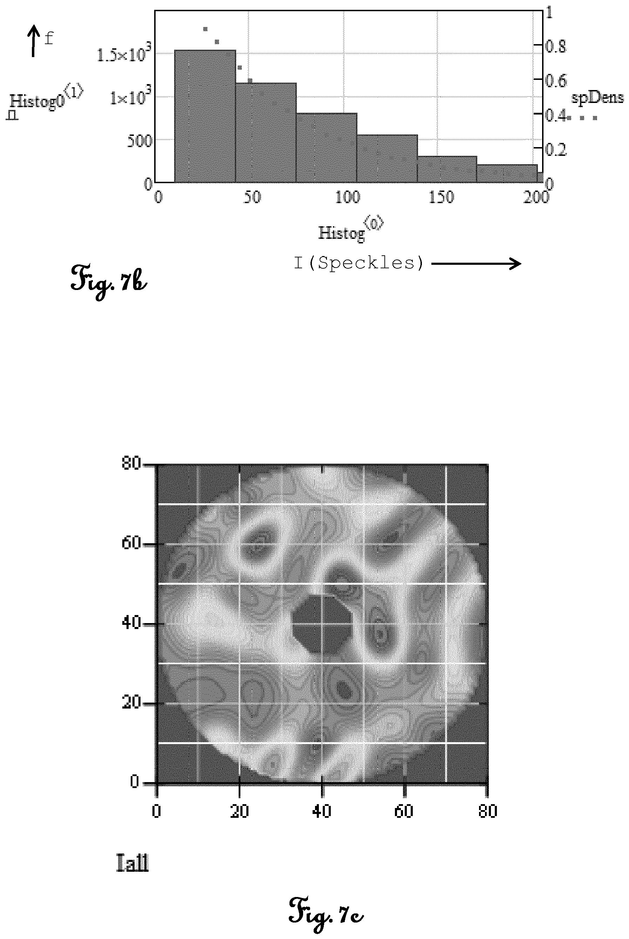

Fig. 7b zeigt die zugehörige Häufigkeitsverteilung f der Intensität I(Speckles) der Speckles. Die Häufigkeit der über die Empfängerfläche "gemessenen" Intensitätswerte ist negativ exponentiell, wie es für quasimonochromatisches Licht typisch ist. Eine solche Verteilung hat Kontrastwerte um 100%. Die Balken sind Werte aus einer Simulation zu den Bilddaten von Fig. 7a, und die Punkte folgen einem Verlauf entsprechend einer theoretischen Exponentialverteilung.

Fig. 7c zeigt, in einer zu Fig. 7a analogen Darstellung, die Speckles-Verteilung, die sich für eine polychromatische Messlichtquelle mit 5 Lasermoden in einer Entfernung von 15 m vom lichtstreuenden Objekt in der Querschnittsebene des Empfangsobjektivs ergibt. - Auffällig im Vergleich zu Fig. 7a ist vor allem, dass es kaum noch Stellen ohne Licht gibt.

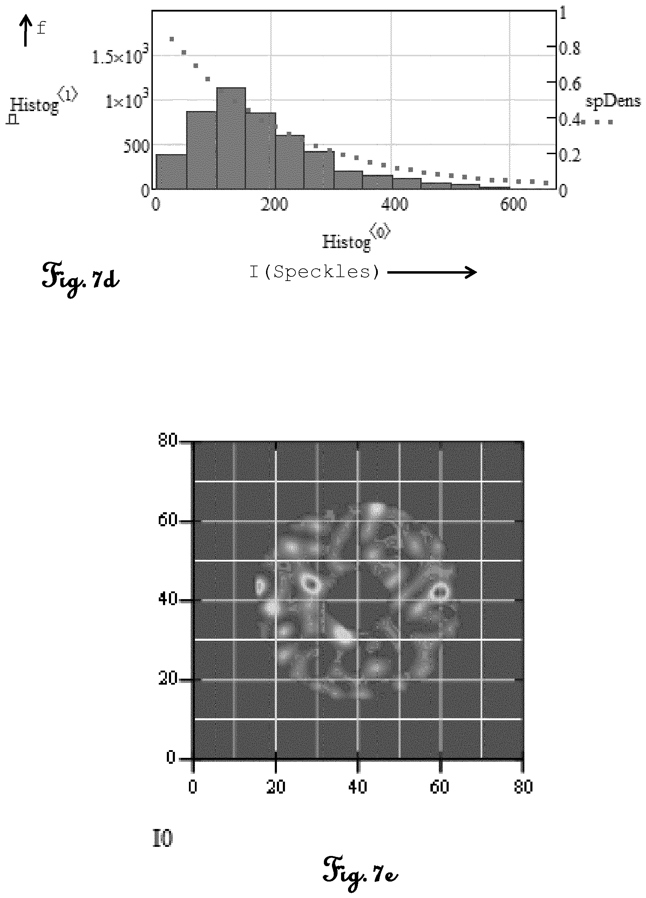

Quantitativ wird dieser Eindruck bestätigt durch die in Fig. 7d zu den Bilddaten von Fig. 7c gehörige Häufigkeitsverteilung der Speckles. Diese weicht jetzt, vor allem im Bereich niedriger Intensitätswerte, deutlich von der durch die Punkte angedeuteten Exponentialverteilung (für monochromatisches Licht) ab. Stattdessen nähert sich die Verteilung einer Gausschen Kurve an: Die Schwankungen der Helligkeit gruppieren sich um einen mittleren Helligkeitswert, die Streuung auf der horizontalen Achse wird kleiner als im Vergleich zum monochromatischen Licht. Stellen ohne Licht sind nun nicht mehr wahrscheinlich. Der unter 5 Lasermoden erwartete Helligkeitskontrast CON beträgt 45% und damit wesentlich kleiner als 100%. Die Balken sind entsprechend Werten aus der Simulation zu Fig. 7c.

Fig. 7e zeigt, zum Vergleich mit Fig. 7a, die Speckles-Verteilung, die sich für eine monochromatische Messlichtquelle in einer Entfernung von 5 m vom lichtstreuenden Objekt in der Querschnittsebene des Empfangsobjektivs ergibt. - Dieses Simulationsbild zeigt, dass die Speckles-Grösse auf der Empfängerfläche mit abnehmender Distanz kleiner wird. Der Einfluss der Speckles kann also auch von der Distanz zum lichtstreuenden Objekt abhängen.

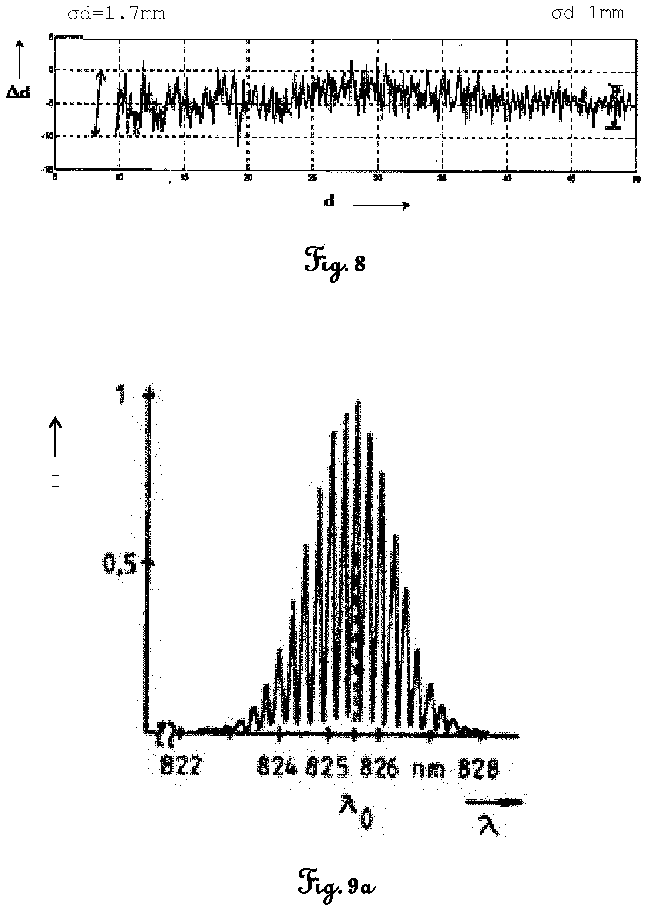

Fig. 8 zeigt, entsprechend einer Messanordnung mit einer monochromatischen Lichtquelle, mit der die in den Figuren 7a, 7c und 7e dargestellten Speckles-Verteilungen beobachtet werden, den scheinbaren Offset $\Delta d$ und die Streuung $\sigma d$ der aus der Bildauswertung abgeleiteten Distanzwerte als Funktion der Messdistanz d zum lichtstreuenden Objekt. Das Distanz-Rauschen $\sigma d$ weist eine Grössenordnung von 1 mm auf und nimmt bei dieser Anordnung mit zunehmender Distanz ab.

Fig. 9a zeigt ein typisches Spektrum einer FP-Laserdiode bei multimodaler Emission und gepulster Betriebsart. Im Wesentlichen weist das Spektrum in etwa M=10 Longitudinalmoden auf. Die emittierte Zentralwellenlänge $\lambda_0$ beträgt hier 825.5 nm. Seedstrahlung mit einer solch kurze Wellenlänge könnte mittels eines Kristallverstärkers auf die für geodätische LIDARs erforderliche Emissionsenergie gebracht werden. Mehr im Sinne der Erfindung wäre eine Fabry-Perot-Seedlaserdiode bei Wellenlänge von 1500nm kombiniert mit einem ER-dotierten Faserverstärker (EDFA). Einerseits weist eine 1500nm-FP-Laserdiode typisch wenigstens 20 Lasermoden auf und EDFA sind kostengünstig. Bei einer solchen Anordnung ist eine Kontrastminderung auf CON < 25% zu erwarten.

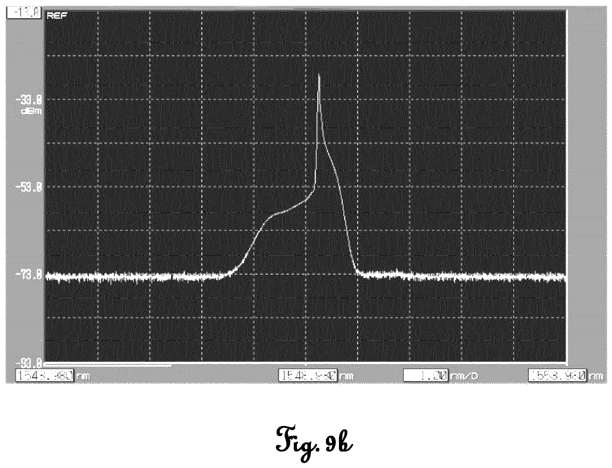

Fig. 9b zeigt, für einen Vergleich mit Fig. 9a, das Spektrum einer DFB-Laserdiode bei einzelmodaler Emission und gepulster Betriebsart. Horizontal, also als "x-Achse", dargestellt, ist der vermessene Spektralbereich $\lambda$ von 1543.98 nm bis 1553.98 nm, senkrecht dazu, also als "y-Achse", dargestellt, ist die gemessene relative Intensität. Die an dem Peak erkennbare Emissionswellenlänge beträgt etwa 1549 nm.

Faserverstärker werden in der Regel mit einer DFB-Laserdiode als "Seed-Laser" betrieben, um die verstärkte spontane Emission möglichst gut zu unterdrücken. DFB-Laser haben aber den Nachteil, einen starken Speckles-Kontrast zu erzeugen. Daher wird nach dem erfinderischen Modell bevorzugt, eine spektral breitbandig emittierende Seed-Quelle zu verwenden.

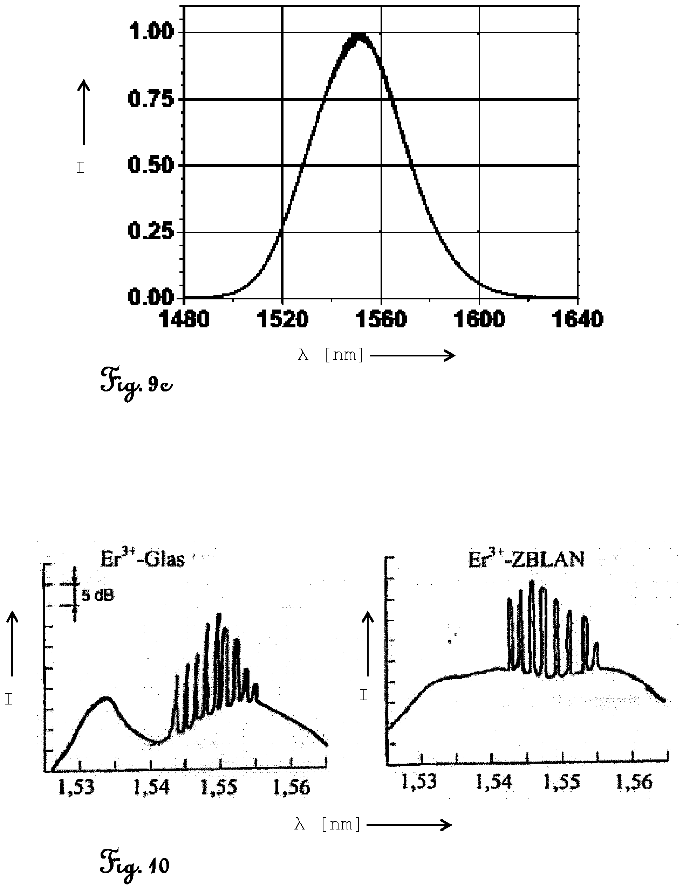

Fig. 9c zeigt das Spektrum einer SLD-Diode, als Bestandteil einer Lichtquelle für ein erfindungsgemässes Distanzmessgerät, mit breitbandiger Emission ohne Spektrallinien, bei gepulster Betriebsart. Dargestellt ist die auf 1 im Maximum normierte relative Intensität I, in willkürlichen Einheiten a.u., als Funktion der Wellenlänge A, gemessen in Nanometern nm. Diese Lichtquelle (SLD) für eine erfindungsgemässe Distanzmessvorrichtung weist ein kontinuierliches und breites Spektrum mit einer Breite von mindestens 5 nm und maximal 50 nm auf. Die emittierte Zentralwellenlänge beträgt etwa 1550 nm (SLD-761-HP2-SM-1550). Damit das optisch modulierte Signal ausreichend stark ist, wird die SLD mit einem optischen Verstärker, vorzugsweise mit einem EFDA, kombiniert.

Fig. 10 zeigt das spektrale Emissionsprofil eines Signals mit einer spektral multimodalen Laserdiode nach einem Faserverstärker, basierend auf $Er^{3+}$-Glas (links) und $Er^{3+}$-ZBLAN (rechts), nach einmaligem Durchlauf des Seed-Lichts der Seedquelle durch den Verstärker. Die dem Linienspektrum unterlegte, kontinuierliche Kurve zeigt ein "ASE"-Spektrum. (ASE = "amplified spontaneous emission" des Verstärkers). Der hier verwendete Faserverstärker ist ohne einen ASE-Sperrfilter ausgerüstet. Üblicherweise wird noch in den Strahlengang ein optisches Bandbassfilter eingefügt, welches lediglich den Spektralbereich des Linienspektrums emittieren lässt.

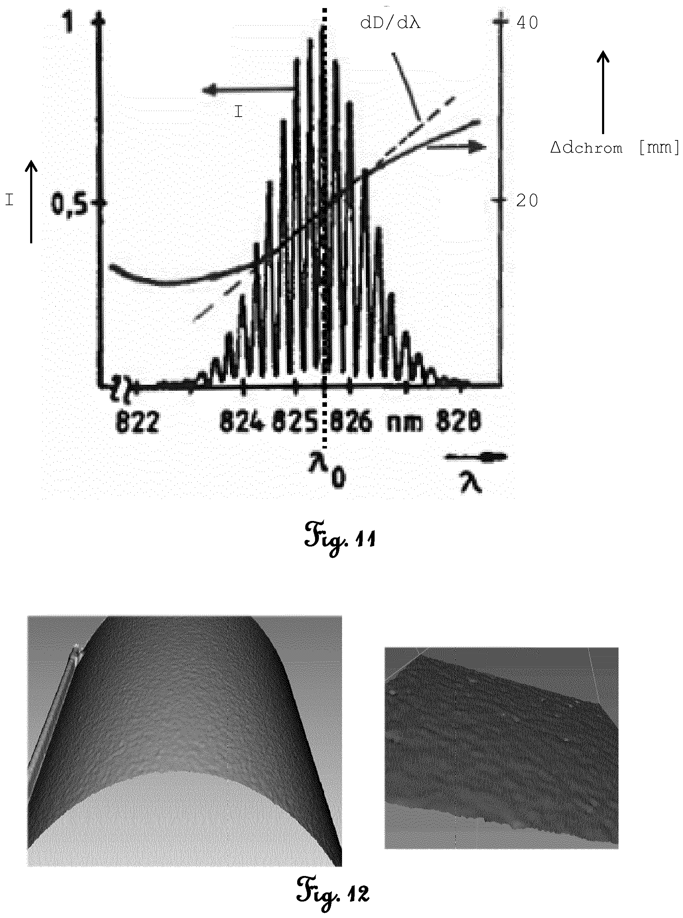

Fig. 11 illustriert den sogenannten "chromatic delay $\Delta$dchrom" oder "chromatic distance-offset", gemessen in Millimetern mm, einer modulierten Lichtquelle als Mechanismus zur Entstehung von "Bumpy Surfaces", mit einer Lichtquelle, deren Spektrum beispielhaft in Fig. 5a dargestellt wurde. Der "chromatic delay $\Delta$dchrom" oder "chromatic distance-offset" erzeugt die scheinbaren Höhenunterschiede, also die scheinbare Welligkeit oder Rauigkeit, einer vermessenen Oberfläche, die sich durch den Einfluss der Speckles im abgeleiteten Ergebnis einer Distanzmessung niederschlägt.

Präziser ausgedrückt: "Chromatic Delay" beschreibt die wellenlängenabhängige Laufzeit eines Lichtpulses. Da den Speckles Wellenlängen zugeordnet sind und jeder Wellenlänge wiederum ein spezifisches Distanzoffset zugeordnet ist, erzeugt jedes Speckles-Feld eine eigene Messdistanz. Die mit den Speckles-Mustern verbundenen Intensitäten, welche den Distanzmessempfänger treffen, sind stochastisch verteilt und variieren je nach Oberfläche und Distanz; dieses führt zu gemessenen scheinbaren Distanzvariationen beim Bewegen des Laserstrahls über den zu scannenden Gegenstand.

- Beim Verschwenken des Laserstrahls über die zu vermessende Objektoberfläche werden Distanzwerte mit Abweichungen gemessen.
- Die Abweichungen sind korreliert mit der transversalen Ausdehnung des Laserspots.

Mittels des chromatischen Delays und der jeweiligen Speckles-Verteilung entstehen daher die wellenartigen Distanzabweichungen an vermessenen Oberflächen (also in den Messdaten).

Der "Chromatic Delay" von Halbleiterlaserdioden und von Superlumineszenzdioden (SLD) lässt sich im Mittel erheblich reduzieren durch eine sogenannte Burstmodulation. Dabei wird nicht ein einziger Lichtimpuls im Nanosekundenbereich sondern ein ganzer Pulszug in derselben Zeit emittiert. Dies erfordert eine spezielle elektronische Ansteuerung, welche mit einer Chip-on-Board Technik realisierbar ist.

Fig. 12 verdeutlicht das Problem einer vermeintlichen, durch Speckles induzierten, gemessenen Oberflächenrauigkeit oder Welligkeit anhand von zwei Beispielen von mit einem DFB-Laser gescannten Oberflächen, links einer gekrümmten Oberfläche eines Objekts in der Art eines Rohrs, rechts einer ebenen Oberfläche. Die Oberflächen zeigen ein Hell-Dunkel-Muster ("Inhomogeneous Intensity") und eine Rauheit, die nicht der tatsächlichen Beschaffenheit der Oberfläche entspricht.

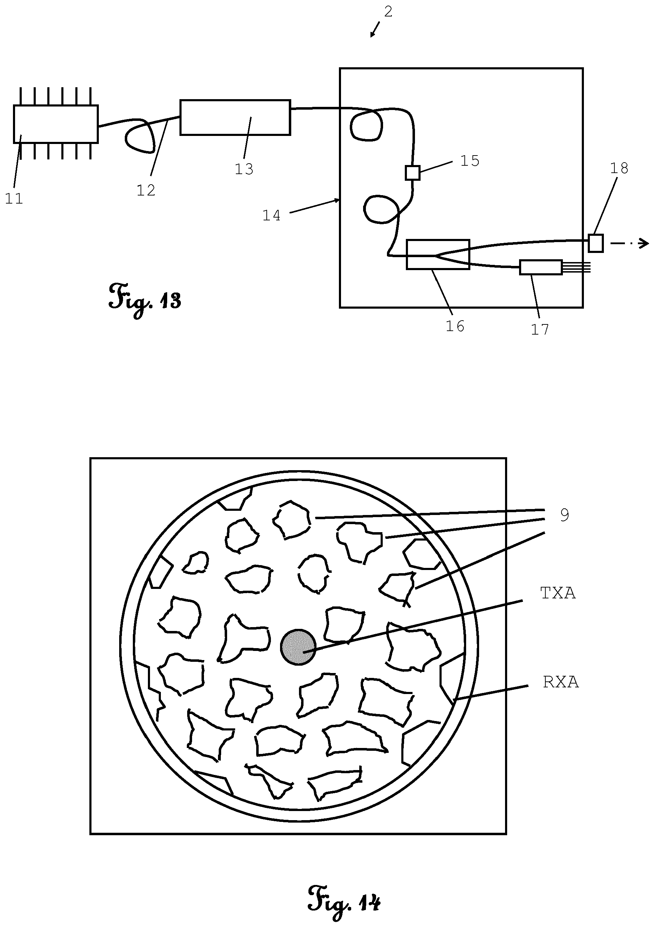

Fig. 13 zeigt ein Blockschaltbild von einem Ausführungsbeispiel für erfindungsgemässe Lichtaussendemittel 2 für eine Distanzmessvorrichtung, mit einer SLD als primärer Lichtquelle 11 und einem der SLD im optischen Weg nachgeschalteten (und durch die SLD "geseedeten", also "SLD-seeded") optischen Verstärker 14, ausgebildet als ein Faserverstärker, und verdeutlicht damit einen ersten Aspekt der vorliegenden Erfindung, nämlich die Verminderung störender Einflüsse von Speckles durch Auswahl einer für den Einsatz optimalen Lichtquelle. Das Emissionslicht der SLD wird über einen Lichtleiter 11 und einen optischen Isolator 13 dem Faserverstärker 14 zugeführt. Dieser umfasst beispielsweise einen ASE-Filter 15, einen optischen Koppler 16 und einen Pumplaser 17. Das verstärkte Licht der SLD verlässt dann den Faserverstärker 14 an einem Lichtquellen-Ausgang 18, ab dem es für eine Distanzmessung verfügbar ist.

Der Lichtleiter des Faserverstärkers 14 und die nachfolgende Ausgangsfaser 18 sind in der Regel als räumliche Singlemodelichtleiter ausgebildet. Inzwischen sind aber auch Lichtleiter bekannt und erhältlich, die einen Kerndurchmesser grösser als der Beugungslimit aufweisen (large core fiber) und trotzdem eine beinahe reine Grundmode-Abstrahlung erzeugen, dies wird erreicht durch eine stark reduziertes intermodales Streuverhalten, dadurch bleibt der Fasergrundmode über eine Länge bis zu einigen Metern Faserlänge erhalten. Der Faserkerndurchmesser kann dabei bis ca 3x über der Monomodebedingung liegen, was bei einer Wellenlänge von 1.55 $\mu$m einem Kernradius von 15 $\mu$m entspricht. Solche "large mode field" Lichtleiter haben den Vorteil, dass auch mit flächenemittierenden LED oder Breitstreifenlaserdioden effektiv Licht in den Kern der Verstärkerfaser eingekoppelt werden kann. Breitstreifenlaser haben ein Multimoden-Linienspektrum mit einem unterlagerten kontinuierlichen LED-artigen Emissionsanteil, was den Speckles-Kontrast effektiv reduziert.

Als primäre Lichtquelle 11 eignen sich neben SLD auch andere Lichtquellen mit partieller oder fehlender Kohärenz wie VCSEL, OLED, high radiance LED oder Miniatur-Gasentladungslampen, welche beispielsweise in Smartphones eingesetzt werden.

Fig. 14 verdeutlicht einen zweiten Aspekt der Erfindung, nämlich eine Verminderung des Einflusses bzw. Kontrasts durch die Speckles 9 mittels einer statistischen Mittelung über ein Empfangsbild einer gross ausgedehnten Empfangspupille mit einer Empfangsapertur RXA, in der ein, durch eine polychromatische Lichtquelle induziertes, empfangenes Speckles-Muster empfangen wird, wobei die Empfangsapertur ARX sehr viel grösser ist als die Sendeapertur TXA der das Messlicht aussendenden Lichtquelle.

Die mittlere Speckles-Grösse entspricht bei typischen Distanzmessvorrichtungen, zumindest bei mittleren und grossen Distanzen, in etwa der Sendeapertur TXA. Gestaltet man die Empfangsapertur RXA um einiges grösser als die Sendeapertur TXA, so dass M Speckles darin aufgenommen werden, dann kann ein Mittelungsprozess über M Speckles stattfinden, und die relative Intensitätsvariation sinkt um Quadratwurzel M. Das Speckles-Rauschen ist dadurch um Quadratwurzel M reduziert.

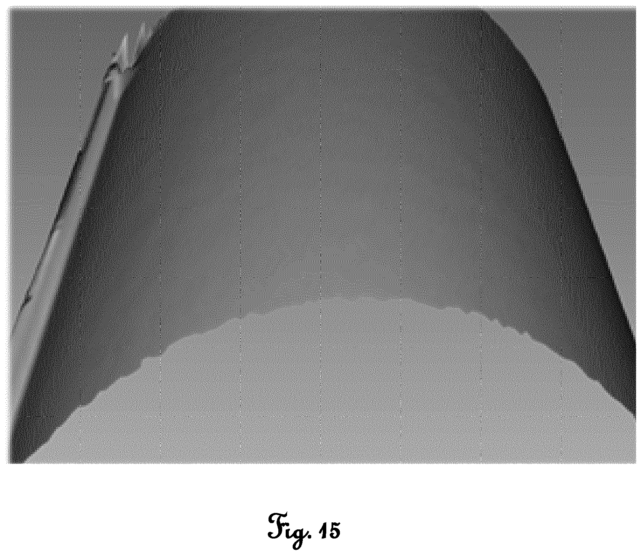

Fig. 15 illustriert ein Messresultat mit, erfindungsgemäss, einem breitbandigen Multimode-Laser und einem grossen Aperturverhältnis RXA/TXA, welches Bild zu vergleichen ist mit der Darstellung in der linken Hälfte von Fig. 12: Diese Graphik zeigt denselben Rohrauschnitt wie Fig. 12, hier nun gemessen mit einem Multimode-Laser mit einer spektralen Breite von 5nm und bestehend aus mehr als 20 Moden. Sowohl die Helligkeitsvariationen als auch die Welligkeit der gemessenen Oberfläche sind nun erheblich geringer.

Es versteht sich, dass diese dargestellten Figuren nur mögliche Ausführungsbeispiele schematisch darstellen. Die verschiedenen Ansätze können ebenso miteinander wie mit Verfahren und Geräten des Stands der Technik kombiniert werden.

## Patentansprüche

1. Elektrooptischer Distanzmesser (1), insbesondere für einen Laserscanner, Lasertracker, Profiler, Theodolit oder eine Totalstation, mit wenigstens

   • Lichtaussendemitteln (2) zum Aussenden wenigstens eines Lichtsignals, insbesondere zum Aussenden eines gepulsten Lichtsignals,
   • einem Empfänger (3) zum Detektieren des von einem Zielobjekt (5) zurückgestreuten Lichtsignals, und
   • einer Steuer- und Auswertekomponente zum Bestimmen einer Distanz zum Zielobjekt (5), insbesondere wobei das Bestimmen auf das Pulslaufzeitmessverfahren basiert, wobei die Lichtaussendemittel (2) wenigstens aufweisen
   • eine primäre Lichtquelle (11) und
   • einen der primären Lichtquelle (11) nachgeschalteten optischen Verstärker (14), wobei ein aktiv gepumptes Medium des optischen Verstärkers (14) Resonator-los als Lichtverstärker dient, insbesondere wobei der optische Verstärker genau dazu vorgesehen und ausgebildet ist, um mit einer Modulationsfolge mit einem kurzen und/oder langen Duty-Cycle betrieben zu werden, **dadurch gekennzeichnet, dass** die primäre Lichtquelle eine spektral breitbandige Lichtquelle ist.

2. Distanzmesser nach Anspruch 1,
   **dadurch gekennzeichnet, dass**
   die primäre Lichtquelle (11) in einem Einzelimpuls-Modus betreibbar ist.

3. Distanzmesser nach Anspruch 1 oder 2,
   **dadurch gekennzeichnet, dass**

die primäre Lichtquelle (11) in einem Burstmode betrieben wird.

4. Distanzmesser nach einem der Ansprüche 1 bis 3,
**dadurch gekennzeichnet, dass**
die primäre Lichtquelle (11) ausgebildet ist als eine superlumineszente Diode (SLD), insbesondere mit einer spektralen Emissionsbreite von zwischen 7 nm und 50 nm, oder als eine Kombination aus mehreren superlumineszenten Dioden (SLDs) .

5. Distanzmesser nach einem der Ansprüche 1 bis 3,
**dadurch gekennzeichnet, dass**
die primäre Lichtquelle (11) ausgebildet ist als eine Hochleistungs-lichtemittierende Diode "High Radiance LED".

6. Distanzmesser nach einem der Ansprüche 1 bis 3,
**dadurch gekennzeichnet, dass**
die primäre Lichtquelle (11) ausgebildet ist als eine Halbleiterlaserdiode, welche mehrere Moden und polychromatisches Licht mit mehreren Spektrallinien aussendet.

7. Distanzmesser nach einem der Ansprüche 1 bis 3,
**dadurch gekennzeichnet, dass**
die primäre Lichtquelle (11) ausgebildet ist als eine Breitstreifen-Laserdiode oder VCSEL-Laserdiode (Vertical Cavity Surface Emitting Laser), welche spatial mehrmodig und polychromatisches Licht, insbesondere mit einer spatialen Emissionsbreite von zwischen 10 $\mu$m und 300 $\mu$m,
aussendet.

8. Distanzmesser nach einem der vorangehenden Ansprüche,
**dadurch gekennzeichnet, dass**
die primäre Lichtquelle (11), insbesondere ausgebildet als superlumineszente Diode (SLD), direkt modulierbar ist durch Subnanosekunden-Pulse.

9. Distanzmesser nach einem der vorangehenden Ansprüche,
**dadurch gekennzeichnet, dass**
der der primären Lichtquelle (11) nachgeschaltete optische Verstärker (14) ausgebildet ist als ein mit einem Metall der Seltenen Erden, wie Y, Yb, Pr, Ho, Tm, Er oder Kombinationen davon, dotierter Faserverstärker, insbesondere als ein Glasfaser-Verstärker.

10. Distanzmesser nach Anspruch 9,
**dadurch gekennzeichnet, dass**
der Faserverstärker einen Faserkerndurchmesser aufweist welcher grösser ist als das Beugungslimit, insbesondere mit einer so genannten "large core" Faser.

11. Distanzmesser nach einem der Ansprüche 1 bis 8,
**dadurch gekennzeichnet, dass**
der der primären Lichtquelle (11) nachgeschaltete optische Verstärker (14) ausgebildet ist als ein Raman-Verstärker, insbesondere als ein SiO$_2$-Faserverstärker.

12. Distanzmesser nach einem der Ansprüche 1 bis 8,
**dadurch gekennzeichnet, dass**
der der primären Lichtquelle (11) nachgeschaltete optische Verstärker ausgebildet ist als ein Halbleiter-Verstärker, insbesondere basierend auf einem Material wie SOA.

13. Distanzmesser nach einem der vorangehenden Ansprüche,
**dadurch gekennzeichnet, dass**
die Fläche der Empfangsapertur (RXA) des Empfängers wenigstens 50 Mal grösser ist als die Querschnittsfläche des Sendebündels bezogen auf denselben Abstand zum Zielobjekt.

14. Distanzmesser nach einem der vorangehenden Ansprüche,
**dadurch gekennzeichnet, dass**
der Empfänger mit einer aus mehreren Segmenten bestehenden Empfangsdiode, insbesondere einer mehrsegmentigen PIN-Diode oder APD, oder mit einem Autofokus ausgerüstet ist.

15. Vermessungsgerät, insbesondere Laserscanner, Lasertracker, Profiler, Theodolit oder Totalstation, mit einem Distanzmesser nach einem der vorangehenden Ansprüche,

**Claims**

1. Electro-optical rangefinder (1), in particular for a laser scanner, laser tracker, profiler, theodolite or a total station, comprising at least:

   • light emission means (2) for emitting at least one light signal, in particular for emitting a pulsed light signal,
   • a receiver (3) for detecting the light signal scatted back from a target object (5), and
   • a control and evaluation component for determining a distance to the target object (5), in particular wherein the determination is based upon the pulse time-of-flight measurement method,

   wherein the light emission means (2) comprise at least

   • a primary light source (11) and
   • an optical amplifier (14) disposed downstream of the primary light source (11), wherein an actively pumped medium of the optical amplifier (14) serves as a light amplifier without a resonator, in particular wherein the optical amplifier is provided and embodied precisely to be operated with a modulation sequence with a short and/or long duty cycle,

   **characterized in that**
   the primary light source is a spectrally broadband light source.

2. Rangefinder according to Claim 1,
   **characterized in that**
   the primary light source (11) is operable in a single pulse mode.

3. Rangefinder according to Claim 1 or 2,
   **characterized in that**
   the primary light source (11) is operated in a burst mode.

4. Rangefinder according to any one of Claims 1 to 3,
   **characterized in that**
   the primary light source (11) is embodied as a superluminescent diode (SLD), in particular with a spectral emission width between 7 nm and 50 nm, or as a combination of a plurality of superluminescent diodes (SLDs).

5. Rangefinder according to any one of Claims 1 to 3,
   **characterized in that**
   the primary light source (11) is embodied as a high power light-emitting diode "high radiance LED".

6. Rangefinder according to any one of Claims 1 to 3,
   **characterized in that**
   the primary light source (11) is embodied as a semiconductor laser diode which emits a plurality of modes and polychromatic light with a plurality of spectral lines.

7. Rangefinder according to any one of Claims 1 to 3,
   **characterized in that**
   the primary light source (11) is embodied as a broad stripe laser diode or VCSEL (vertical cavity surface emitting laser) laser diode which emits spatially multimode and polychromatic light, in particular with a spatial emission width of between 10 $\mu$m and 300 $\mu$m.

8. Rangefinder according to any one of the preceding claims,
   **characterized in that**
   the primary light source (11), embodied in particular as a superluminescent diode (SLD), is directly modulable by sub-nanosecond pulses.

9. Rangefinder according to any one of the preceding claims,
**characterized in that**
the optical amplifier (14) disposed downstream of the primary light source (11) is embodied as a fiber amplifier, in particular as a glass fiber amplifier, doped with a rare earth metal such as Y, Yb, Pr, Ho, Tm, Er or combinations thereof.

10. Rangefinder according to Claim 9,
**characterized in that**
the fiber amplifier has a fiber core diameter that is greater than the diffraction limit, in particular comprising a so-called "large core" fiber.

11. Rangefinder according to any one of Claims 1 to 8,
**characterized in that**
the optical amplifier (14) disposed downstream of the primary light source (11) is embodied as a Raman amplifier, in particular as an $SiO_2$ fiber amplifier.

12. Rangefinder according to any one of Claims 1 to 8,
**characterized in that**
the optical amplifier disposed downstream of the primary light source (11) is embodied as a semiconductor amplifier, in particular based on a material such as SOA.

13. Rangefinder according to any one of the preceding claims,
**characterized in that**
the area of the reception aperture (RXA) of the receiver is at least 50 times larger than the cross-sectional area of the transmission beam in relation to the same distance from the target object.

14. Rangefinder according to any one of the preceding claims,
**characterized in that**
the receiver is equipped with a reception diode consisting of a plurality of segments, in particular a multi-segment PIN diode or APD, or equipped with an autofocus.

15. Surveying instrument, in particular a laser scanner, laser tracker, profiler, theodolite or total station, comprising a rangefinder according to any one of the preceding claims.

**Revendications**

1. Télémètre électro-optique (1), notamment pour un scanneur laser, un laser de relevé, un profileur, un théodolite ou une station totale, comportant au moins

   • des moyens d'émission de lumière (2) destinés à émettre au moins un signal lumineux, notamment à émettre un signal lumineux pulsé,
   • un récepteur (3) destiné à détecter le signal lumineux renvoyé par un objet cible (5), et
   • un composant de commande et d'évaluation destiné à déterminer une distance par rapport à l'objet cible (5), notamment au moyen du procédé de mesure de la durée de propagation de l'impulsion,

   les moyens d'émission de lumière (2) présentant au moins

   • une source lumineuse primaire (11) et
   • un amplificateur optique (14) en aval de la source lumineuse primaire (11), un milieu activement pompé de l'amplificateur optique (14) servant d'amplificateur de lumière sans résonateur, en particulier l'amplificateur optique étant précisément prévu et conçu pour être utilisé avec une séquence de modulation comportant un rapport cyclique court et/ou long,

   **caractérisé en ce que**
   la source lumineuse primaire est une source lumineuse à large bande spectrale.

**2.** Télémètre selon la revendication 1,
**caractérisé en ce que**
la source lumineuse primaire (11) peut être utilisée dans un mode d'impulsion unique.

**3.** Télémètre selon la revendication 1 ou 2,
**caractérisé en ce que**
la source lumineuse primaire (11) est utilisée dans un mode rafale.

**4.** Télémètre selon l'une des revendications 1 à 3,
**caractérisé en ce que**
la source lumineuse primaire (11) est réalisée sous la forme d'une diode superluminescente (SLD), notamment avec une largeur spectrale d'émission entre 7 nm et 50 nm, ou d'une combinaison de plusieurs diodes superluminescentes (SLD).

**5.** Télémètre selon l'une des revendications 1 à 3,
**caractérisé en ce que**
la source lumineuse primaire (11) est réalisée sous la forme d'une diode électroluminescente à haute luminance (*High Radiance LED*).

**6.** Télémètre selon l'une des revendications 1 à 3,
**caractérisé en ce que**
la source lumineuse primaire (11) est réalisée sous la forme d'une diode laser à semi-conducteur qui émet en plusieurs modes et de la lumière polychromatique avec plusieurs raies spectrales.

**7.** Télémètre selon l'une des revendications 1 à 3,
**caractérisé en ce que**
la source lumineuse primaire (11) est réalisée sous la forme d'une diode laser à ruban large ou une diode laser VCSEL (à cavité verticale et à émission par la surface), qui émet de manière spatialement multimodale et de la lumière polychromatique, notamment avec une largeur spatiale d'émission entre 10 $\mu$m et 300 $\mu$m.

**8.** Télémètre selon l'une des revendications précédentes,
**caractérisé en ce que**
la source lumineuse primaire (11), notamment réalisée sous la forme d'une diode superluminescente (SLD), est modulable directement par des impulsions de durée inférieure à la nanoseconde.

**9.** Télémètre selon l'une des revendications précédentes,
**caractérisé en ce que**
l'amplificateur optique (14) en aval de la source lumineuse primaire (11) est réalisé sous la forme d'un amplificateur à fibre dopé avec un métal de terres rares tel que Y, Yb, Pr, Ho, Tm, Er ou des combinaisons de ceux-ci, notamment sous la forme d'un amplificateur à fibre optique.

**10.** Télémètre selon la revendication 9,
**caractérisé en ce que**
l'amplificateur à fibre présente un diamètre d'âme de fibre supérieur à la limite de diffraction, notamment une fibre dite *large core.*

**11.** Télémètre selon l'une des revendications 1 à 8,
**caractérisé en ce que**
l'amplificateur optique (14) en aval de la source lumineuse primaire (11) est réalisé sous la forme d'un amplificateur Raman, notamment un amplificateur à fibre de SiO$_2$.

**12.** Télémètre selon l'une des revendications 1 à 8,
**caractérisé en ce que**
l'amplificateur optique (14) en aval de la source lumineuse primaire (11) est réalisé sous la forme d'un amplificateur à semi-conducteurs, en particulier sur la base d'un matériau comme SOA.

**13.** Télémètre selon l'une des revendications précédentes,
**caractérisé en ce que**

l'aire de l'ouverture de réception (RXA) du récepteur est au moins 50 fois supérieure à la section transversale du faisceau d'émission à la même distance de l'objet cible.

14. Télémètre selon l'une des revendications précédentes,
**caractérisé en ce que**
le récepteur est doté d'une diode réceptrice constituée de plusieurs segments, notamment d'une photodiode à avalanche ou d'une diode PIN à plusieurs segments, ou d'un dispositif de focalisation automatique.

15. Appareil de mesure, notamment scanneur laser, laser de relevé, profileur, théodolite ou station totale, comportant un télémètre selon l'une des revendications précédentes.

*Fig. 1*

*Fig. 2*

*Fig. 3*

p(I,M)

$\dfrac{p(I_k,1)}{p(I_k,2)}$

.....

$\dfrac{p(I_k,6)}{p(I_k,10)}$

**Fig. 4**    I_k

P(I)

σ = 1 μm

σ = 2 μm

σ = 10 μm

**Fig. 5**

Fig. 6

Fig. 7a

**Fig. 7b**

I(Speckles) ⟶

Iall

**Fig. 7c**

*Fig. 7d*

*Fig. 7e*

σd=1.7mm                                                            σd=1mm

Fig. 8

Fig. 9a

Fig. 9b

*Fig. 9c*

*Fig. 10*

Fig. 11

Fig. 12

Fig. 13

Fig. 14

Fig. 15

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1335457 A2

- EP 14185404 A